# EUROPEAN PATENT APPLICATION

(11) **EP 1 617 244 A1**
(43) Date of publication of application: **18.01.2006**
(21) Application number: 04103032.1
(22) Date of filing: 29.06.2004
(51) Int. Cl.: G02B 6/42, G02B 6/02

(54) **Optical device including a Bragg grating and method of manufacturing thereof**

(71) Applicant: STMicroelectronics S.r.l., 20041 Agrate Brianza (Milano) (IT)
(72) Inventor: CHIARETTI, Guido, I-20026, NOVATE MILANESE (MI) (IT)
(74) Representative: Maccalli, Marco

(57) **Abstract**

A method of producing an optical device including a Bragg grating (120) formed in an optical waveguide (115), the method comprising: providing a support substrate (110;310-1,310-2,113;410-1,410-2,413); positioning the optical waveguide with respect to an optical source (105) so as to achieve a desired optical coupling of optical power emitted by the optical source into the optical waveguide; attaching the waveguide to the support substrate (110a,135a;310a,135a;410a,410b) in correspondence of a first location along the waveguide, said first location being at one side of the Bragg grating; attaching the waveguide to the support substrate (110b,135b;310b,135b) in a correspondence of a second location along the waveguide, said second location being at an opposite side of the Bragg grating, so as to freeze a first stress condition in the Bragg grating.

## Description

The present invention relates generally to the field of optics and to optical devices, more specifically to optical communications and, in particular, to the manufacturing of optical devices used in optical communications. Even more particularly, the present invention concerns the aspects related to the manufacturing, including packaging, of optical devices that include Bragg gratings.

In the field of optics, optical devices are known that include Bragg gratings, particularly optical fiber Bragg gratings.

One such device is the so-called external cavity laser, also referred to as fiber grating laser or Hybrid Distributed Bragg Reflector (shortly, HDBR) laser.

As known in the art, a HDBR laser is formed by an active element (the optical source) and a reflector. The active element may comprise a semiconductor chip in which a Fabry-Perot semiconductor laser diode, or a Semiconductor Optical Amplifier (SOA), is integrated. The laser diode or, respectively, the SOA, has a first facet coated with a layer of reflective material, and a second, opposed facet coated with a layer of anti-reflection material. The reflector comprises a Bragg grating, formed in an optical fiber that is coupled to the active element, the second facet of which faces a tip or termination of the optical fiber.

In the PCT application WO 01/91259 a HDBR laser adapted to the use in the field of optical communications, particularly in applications requiring very high transmission capacity (expressed as the transmission distance by the bit rate by the number of optical channels) has been described.

In order to be adapted to the use in such applications, a laser should be capable of being modulated at very high frequency (of the order of some GHz); additionally, it should have a very narrow optical emission spectrum; moreover, the emission wavelength should be very precise and stable in time, compared to the ITU grid.

The aspects inherent to the high-frequency modulation of the HDBR laser are described in the already cited WO 01/91259; without entering into excessive details, in that document it is described how to design the Bragg grating in order to ensure that the laser oscillates on a prescribed mode, even under condition of high-frequency direct modulation.

The narrowness of the optical emission spectrum is an inherent characteristic of HDBR lasers: it is in fact known in literature that this type of lasers have a rather pure continuous wave spectrum.

Emission wavelength precision and stability over time are two additional important requirements to be satisfied, so as to respect the standardized wavelengths specified in the ITU grid, and not to invade, during time, regions of the spectrum adjacent to that associated with the occupied optical communication channel; stability of the emission wavelength is in particular required to reduce, as far as possible, the cross-talk on adjacent channels.

The emission wavelength of an HDBR laser depends on the reflection wavelength of the Bragg grating; as known, the Bragg grating is substantially equivalent to a mirror reflecting optical radiation of a particular wavelength. The commercially available Bragg gratings, e.g. fiber Bragg gratings, exhibit a relatively large tolerance in respect of the grating reflection wavelength, due to production process yield considerations. Thus, unless specific measures are adopted, the resulting emission wavelength of an HDBR laser is rather imprecise.

In order to correct deviations of the laser emission wavelength from the target one, post-manufacturing calibration is necessary during the packaging phase. In particular, the laser emission wavelength can be adjusted by applying a controlled stress to the fiber containing the grating.

Stability of the emission wavelength over time depends on the fact that the controlled stress applied to the fiber during the calibration is kept constant in time. In addition to this, it is to be considered that the grating reflection wavelength is also affected by variations in the operating environment temperature. Under this respect, the Applicant has observed that even in cases where a thermal regulation element such as a Peltier cell is provided in the packaged optical device for thermally stabilizing the laser, the Bragg grating is usually positioned relatively far away from such thermal regulation element, being instead rather close to the package cover; heat originated outside the laser device can thus flow into the laser package and affect the frequency response of the Bragg grating; in particular, the Applicant has observed that there is a linear relationship between the grating reflection wavelength variation and the Bragg grating temperature, with proportionality factor ranging from 0,0089 nm/C to 0,023 nm/C, depending on the specific packaging conditions.

In the light of the state of the art outlined in the foregoing, one of the problems that the Applicant has faced is how to ensure precision and stability of the spectral characteristics of a Bragg grating of the type used for example in HDBR lasers, particularly for high-capacity optical communications applications.

In particular, the Applicant has faced the problem of how to ensure that the optical radiation emitted by an HDBR laser is precise and stable over time, irrespective of changes in the operating conditions.

According to an aspect of the present invention, there is provided a method of producing an optical device including a Bragg grating formed in an optical waveguide. The method comprises:
providing a support substrate;
positioning the optical waveguide on the substrate with respect to an optical source so as to achieve a desired optical coupling of optical power emitted by the optical source into the optical waveguide;
attaching the waveguide to the support substrate in correspondence of a first location along the waveguide, said first location being at one side of the Bragg grating;
attaching the waveguide to the support substrate in a correspondence of a second location along the waveguide, said second location being at an opposite side of the Bragg grating, so as to block the Bragg grating in a first stressed condition, so that the first stress condition is sort of "frozen" in the Bragg grating.

For the purposes of the present invention, by stressed condition it is intended any possible condition of stress applied to the Bragg grating, including a zero- or substantially zero-stress condition.

Other aspects of the present invention concern an optical device, a method of tuning an optical device and a tunable optical device.

The features and advantages of the present invention will be made apparent by the following detailed description of some embodiments thereof, provided merely by way of non-limitative examples, description that will be conducted making reference to the annexed drawings, wherein:
**Figures 1A** to **1F** are extremely schematic views of some of the relevant steps of a manufacturing method according to a first embodiment of the present invention, applied to the production and packaging of an HDBR laser;
**Figure 2** shows, in axonometric view, one of the steps of the manufacturing method;
**Figures 3A** to **3F** are extremely schematic views of some of the relevant steps of a manufacturing method according to a second embodiment of the present invention, applied again to the production and packaging of an HDBR laser;
**Figure 4** is an extremely schematic view of a manufacturing method according to a third embodiment of the present invention, applied to the production and packaging of a different type of optical device including a Bragg grating, particularly a wavelength-selective optical filter; and
**Figure 5** is a schematic diagram of an optical subsystem in which the optical device of **Figure 4** can be used.

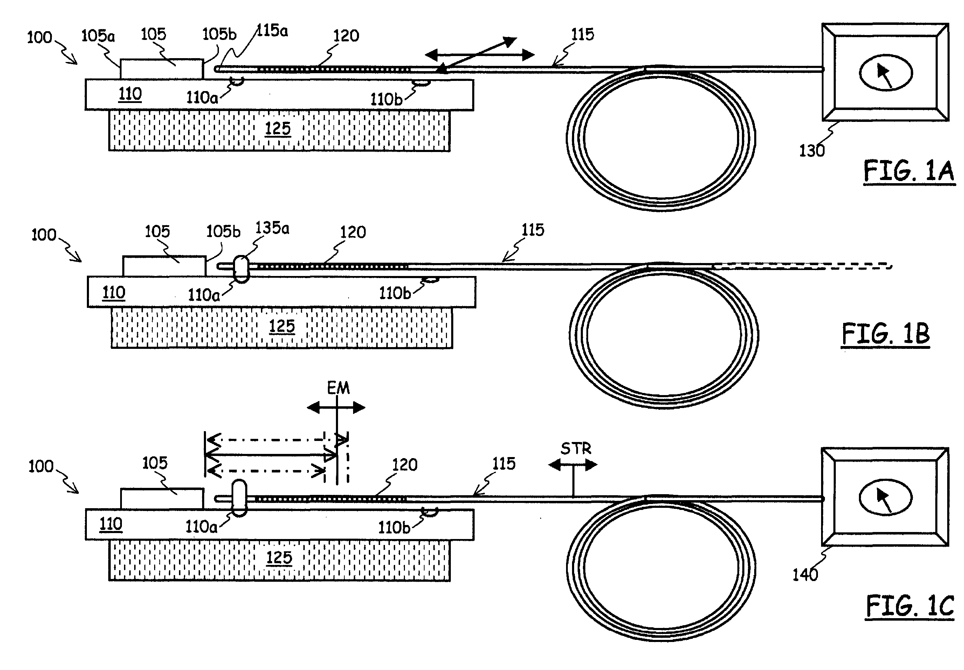

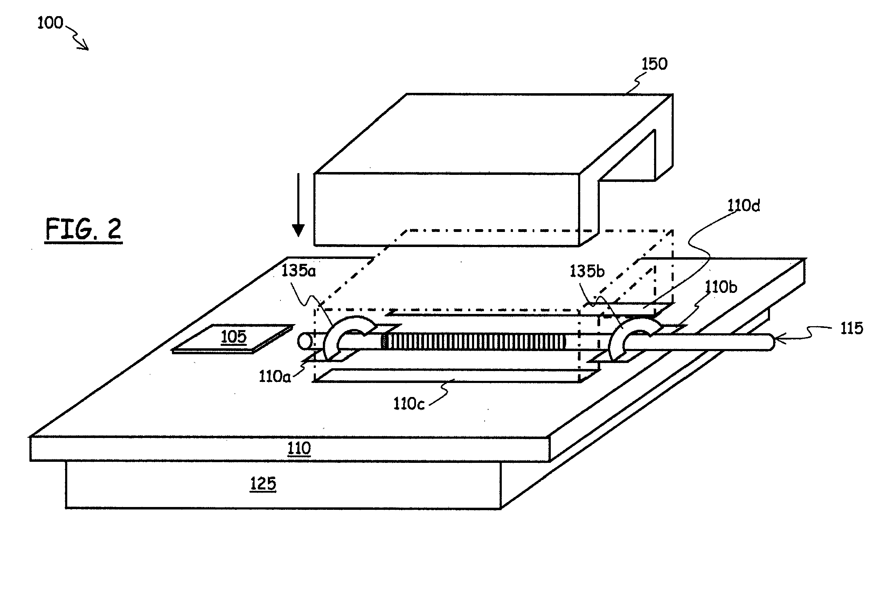

In **Figures 1A** to **1F** and **2** there are schematically shown some of the relevant steps of a manufacturing method according to a first embodiment of the present invention, for the production, up to the packaging, of an optical device including a Bragg grating. In particular, the first embodiment of the invention described relates to the packaging of an HDBR laser.

Making reference to the drawings, an Optical SubAssembly (OSA) **100** includes a semiconductor material chip **105** wherein an optical active element, such as a laser diode, is integrated, attached (typically, bonded), in correspondence of a respective seat, to an OSA support substrate **110,** in a material having sufficiently high thermal conductivity properties, for example of silicon or other semiconductors, SiC, diamond, SiGe, GaAs, InP, copper alloys, metals with low thermal expansion properties.

The optical active element **105,** e.g. the laser diode, comprises for example a PN homojunction, such as of GaAs or InP, or alternatively an heterojunction, such as InP/InGaAsP. By way of example, a GaAs laser can be used in applications that provide for exploiting the first attenuation window of optical fibers, corresponding to wavelengths in the range 0.8 to 0.9 µm; a InP/InGaAsP laser can instead operate in the second and third optical fiber attenuation windows , corresponding to wavelengths of about 1.3 to 1.55 µm. However, the invention is not thus limited, applying as well to emitting sources operating at a shorter wavelength (UV or visible spectrum) or at longer one (near or far IR).

The optical active element **105** has a first and a second opposite facets **105a, 105b** (corresponding to the facets of the chip **105**); the first facet **105a** is an optically reflecting facet (the chip facet is coated by a film of reflecting material), whereas the second facet **105b** is only partially reflecting (the chip facet is coated by a film of low-reflectivity or anti-reflecting material) and forms an output port for the optical radiation.

The optical active element **105** is further provided with electrical terminals (not shown in the drawings for the sake of clarity) for applying a bias and modulation current I for the laser diode.

In order to form a HDBR laser, the laser diode **105** is coupled to an external optical waveguide, particularly an optical fiber **115** in a section of which a Bragg grating **120** is formed. In particular, the second, partially-reflecting facet **105b** of the optical active element **105** is in optical coupling relationship with an input termination **115a** of the fiber **115,** proximate to which the Bragg grating **120** is located.

Techniques for forming Bragg gratings in optical waveguides, particularly optical fibers are known in the art, and are not limitative to the present invention.

Preferably, the Bragg grating **120** is realized according to the teachings provided in the already cited WO 01/91259, which is included herein by reference; in such a way, a HDBR laser capable of being directly modulated at high frequency can be obtained. However, it is intended that the Bragg grating might as well be realized in different ways, not being *per-se* a limitation for the present invention.

Preferably, the input termination **115a** of the fiber **115** is treated so as to form a lens, which allows enhancing the optical coupling to the facet **105b** of the optical active element **105.**

The OSA support substrate **110** is mounted to a thermal regulation element, e.g. a peltier cell **125,** for stabilizing the temperature of the OSA, particularly of the optical active element **105** and the Bragg grating **120,** with the purpose of reducing or eliminating thermal drifts of the two critical elements of the OSA.

According to the first embodiment of the invention being described, the optical active element **105** is first attached (bonded) to the OSA support substrate **110.** Then, the fiber **115** is positioned on the OSA support substrate **110,** having care to ensure the precise alignment, and the distance of the fiber input termination **115a** with respect to the radiation-emitting, second facet **105b** of the element **105**, so as to ensure good optical coupling. To this purpose, as schematically depicted in **Figure 1A,** the optical power coupled into the fiber **115** may be measured, by a suitable instrument **130**, for example an optical power meter connected to an output termination of the fiber **115**. While the fiber **115** is moved on the OSA substrate **110** with respect to the optical active element **105**, the optical power emitted by the latter and coupled into the fiber is monitored by the optical power meter **130**; the correct positioning of the fiber **115** is considered achieved when the target optical power is measured by the instrument **130**.

Once the fiber **115** has been correctly positioned, the fiber **115** is attached to the OSA support substrate **110** at a first attachment point. In particular, as shown in **Figure 1B,** the fiber **115** is attached, e.g. bonded by solder **135a,** to the OSA support substrate surface at a first fiber bonding site **110a,** for example a metallization provided on the substrate **110.** The fiber **115** is preferably bonded to the substrate **110** in a region intermediate between the input termination **115a** and the Bragg grating **120.** For example, in order to bond the fiber to the substrate **110,** as described in WO 01/91259, the fiber **115** may be externally metallized in a fiber section region including the fiber attachment region, for example in the fiber section from the input termination to the Bragg grating; in correspondence of the substrate bonding site **110a,** a micro-heater may be integrated, *e.g.* a resistor (not shown in the drawings); after the fiber has been properly positioned in the way previously described, the micro-heater is energized so as to generate, for example by Joule effect, sufficient heat to cause reflow or reliquification of the solder alloy that bonds the fiber to the substrate. Other attachment techniques are however possible, the way the fiber is attached to be substrate not being a limitation for the present invention.

In this way, a HDBR laser emitting the desired optical power is obtained; the emission spectrum is relatively narrow, a peculiarity of this type of lasers; the emission wavelength is determined by the frequency response of the Bragg grating in a stressed condition that corresponds to a substantially zero stress, i.e. such a wavelength corresponds to the reflection wavelength of the Bragg grating in a substantially zero-stress condition.

In order to tune the laser emission wavelength to the desired value, particularly according to the ITU wavelengths grid, which may, and typically does, differ from the above-mentioned substantially zero-stress emission wavelength, the Bragg grating **120** is applied a controlled stress; in particular, as schematically shown in **Figure 1C,** the fiber **115** is applied an axial stress **STR** from the side opposite the input termination **115a** by properly pushing or pulling the fiber, e.g. by hand or in automated way ; this causes the fiber section wherein the Bragg grating **120** is formed to be either stretched, in case the axial stress **STR** is a tensile, extension stress, or compressed, in case the axial stress **STR** is a compressive stress. While the fiber **115** is applied the stress **STR,** the emission wavelength of the HDBR laser is monitored, using a suitable instrument **140,** such as a spectrum analyzer connected to the output termination of the fiber **115.** The axial stress applied to the fiber **115** varies the position of the equivalent mirror **EM** of the Bragg grating with respect to the facet **105a** of the optical active device **105;** in particular, an extension stress causes a shift of the wavelength towards the red, while a compressive stress causes the emission wavelength to be shifted towards the blue.

For example, starting from a substantially zero-stress emission wavelength of 1540 nm, by applying an axial stress of approximately 90 N, the emission wavelength may be varied of approximately 1.1 nm, or 7 nm if a tensile stress of 0,4 GPa is applied.

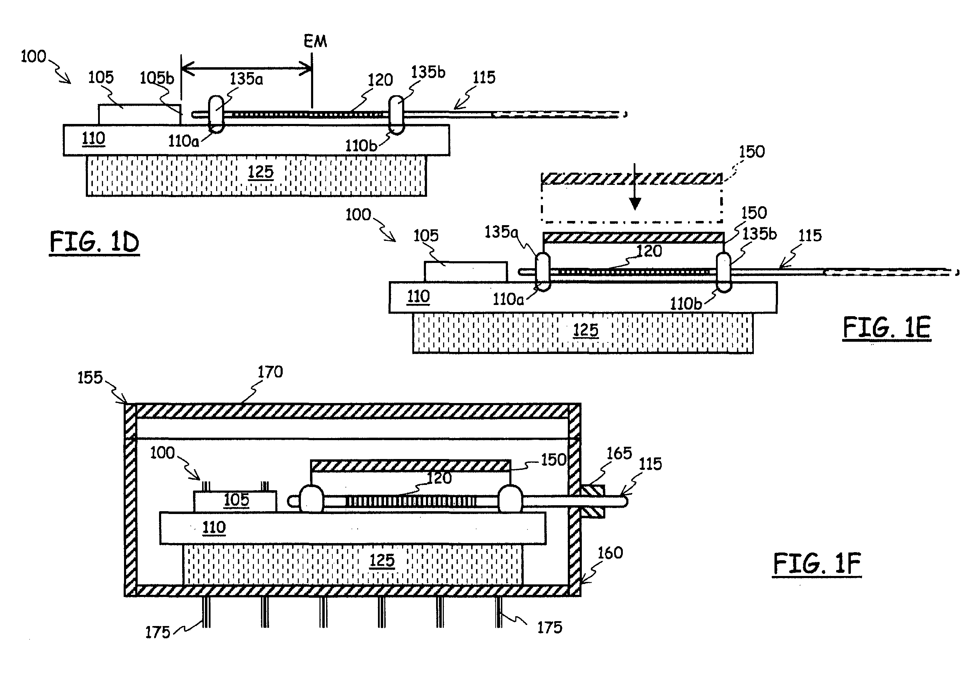

Once the target emission wavelength is reached, the corresponding stress is "frozen" in the Bragg grating, by attaching the fiber **115** to the OSA support substrate **110** at a second attachment point. In particular, as shown in **Figure 1D,** the fiber **115** is attached, *e.g.* bonded by solder **135b**, to the OSA support substrate surface at a second fiber bonding site **110b,** *e.g.* a metallization provided on the substrate **110.** The fiber **115** is preferably bonded to the substrate **110** in a region downstream (coming from the input termination) the fiber section in which the Bragg grating **120** is formed. The bonding technique may for example be the same described in the foregoing, in connection with the first bonding.

Having thus frozen into the Bragg grating the stress required to achieve the target emission wavelength, by attachment, particularly bonding the fiber **115** to the OSA, in the two attachment points, it is ensured that the stress applied to the fiber is maintained during time, and that the Bragg grating is kept in the corresponding stress condition, so that the precision of the emission wavelength in time is guaranteed.

However, variations in the operating temperature, particularly the temperature of the Bragg grating, may cause the emission wavelength to change in time.

Temperature variations of the OSA, particularly of the Bragg grating **120** are reduced by the thermal regulation element, e.g. the peltier cell **125.**

However, the Applicant has observed that in some cases it might be preferable to improve the thermal regulation capabilities of the peltier cell **125.** Thus, as schematically shown in **Figures 1E** and **2,** a cover or cap **150** of a thermally-conductive material, *e.g.* made of silicon or other semiconductors, or of metals, is provided, of shape and dimensions such that the cap **150** can be placed astride of the fiber **115,** so as to preferably span for substantially the whole length of the fiber section containing the Bragg grating **120.** The cap **150,** having for example a "C"-shaped cross-section, is attached, preferably bonded to the OSA substrate **110** at two preferably elongated bonding areas **110c, 110d,** for example metal strips that extend aside the fiber section containing the Bragg grating 120, between the first and second fiber bonding sites **110a** and **110b**. The cap **150,** being of thermally-conductive material and being in thermal contact with the substrate **110,** which in turn is thermally-regulated by the peltier cell **125,** ensures that, in operation, the temperature of the Bragg grating **120** is kept substantially constant, irrespective of temperature variations in the environment surrounding the Bragg grating.

The OSA **100** may at this point be placed in a respective package **155,** as schematically shown in **Figure 1F.** The package **155** may for example be in a suitable metal material (for example in KOVAR), preferably exhibiting good properties of heat dissipation, but scarcely dilatable with increase of temperature. The package **155** has a hollow bottom **160,** adapted to accommodate the OSA **100** and provided with a lateral passage **165** for the optical fiber **115,** and a cover **170.** Reophores **175** protrude from the package, the ends thereof internal to the package being electrically connected to electric terminals of the OSA **100** (not shown for the sake of clarity).

Thanks to the provision of the cap **150,** even though the Bragg grating **120** is positioned relatively far away from the peltier cell **125,** close to the package cover **170,** the heat originated outside the package **155,** possibly flowing thereinto, does not substantially affect the frequency response of the Bragg grating, whose operating temperature is kept regulated by the fact that the cap **150** is thermally-conductive, and is placed in thermal contact with the substrate **110,** in turn thermally-stabilized by the thermal regulation element **125.** The cap **150** acts in other words as a thermal shield for the Bragg grating **120.**

It is observed that the OSA support substrate **110** might as well be mounted onto the peltier cell **125** at the time the OSA **100** is inserted into the package **155,** instead than before.

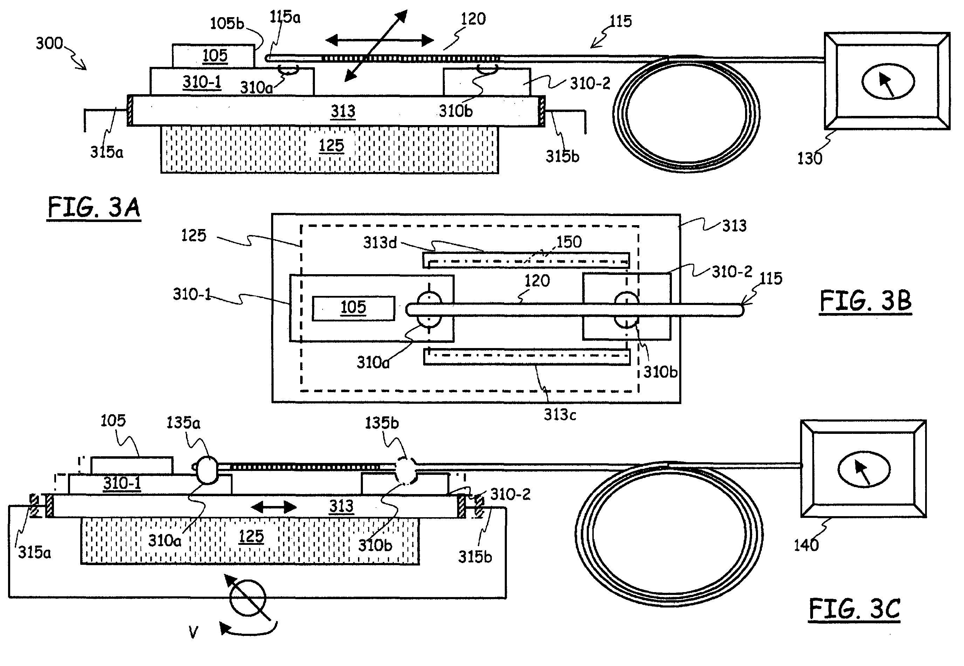

Another embodiment of the present invention is presented in **Figures 3A** to **3F**. Differently from the previously described embodiment, an OSA **300** comprises a first and a second OSA support substrates **310-1** and **310-2,** which, similarly to the OSA support substrate **110** of the previous embodiment, are made of a material having sufficiently high thermal conductivity properties, for example of silicon or other materials, as mentioned previously. The optical active element **105** is attached, e.g. bonded to the first OSA substrate **310-1;** the first OSA substrate **310-1** includes, in addition to the bonding area for the chip of the optical active element **105,** a first fiber bonding site **310a**, intended for bonding the fiber **115.** The second OSA substrate **310-2** includes a second fiber bonding site **310b** for bonding the fiber **115;** the first and second fiber bonding sites **310a** and **310b** are for example metallizations provided on the substrates **310-1** and **310-2,** respectively.

The first and second OSA substrates **310-1** and **310-2** are soldered to a common substrate **313,** in a thermally-conductive material. In particular, the common substrate **313** is made of a controllably deformable material, particularly a piezoelectric material, and is provided with a first and a second electrodes **315a** and **315b** adapted for applying a suitable electric field to the common substrate **313,** so as to induce therein a controlled deformation.

The fiber **115** is first positioned having care to ensure the precise alignment, and the distance of the fiber input termination **115a** with respect to the radiation-emitting, second facet **105b** of the element **105,** so as to ensure good optical coupling. As in the first embodiment described before, the optical power coupled into the fiber **115** may be measured by a suitable instrument **130,** for example an optical power meter connected to an output termination of the fiber **115.** While the fiber **115** is moved on the OSA substrate **110** with respect to the optical active element **105,** the optical power emitted by the latter and coupled into the fiber is monitored by the optical power meter **130;** the correct positioning of the fiber **115** is considered achieved when the target optical power is measured by the instrument **130.**

Once the fiber **115** has been correctly positioned, it is attached to the first OSA substrate **310-1** at a first attachment point. In particular, as shown in **Figure 3C,** the fiber **115** is attached, e.g. bonded by solder **135a,** to the first OSA substrate **310-1** at the first fiber bonding site **310a,** preferably in a region of the fiber intermediate between the input termination **115a** and the Bragg grating **120.** The bonding may for example be accomplished in the way described in the foregoing.

Two exemplary procedures are presented hereinafter that are adapted to tune the emission wavelength of the laser.

A first tuning procedure calls for attaching, *e.g*. bonding (by solder) **135b** the fiber **115** to the second OSA substrate **310-2,** at the second fiber bonding site **310b** in an initial stress condition of substantially zero stress, without controlling the emission wavelength before attaching the fiber, but having care to ensure that the piezoelectric material common substrate **313** is not in either one of the two full-scale conditions (*i*.*e*., maximum extension or maximum contraction); this can for example be done by applying to the piezoelectric common substrate **313** a suitable voltage V through the electrodes **315a** and **315b,** where by suitable voltage there is intended a voltage such that the piezoelectric material is not in a full-scale condition (i.e., neither a zero voltage nor a maximum applicable voltage), and keeping the common substrate biased in this way while attaching the fiber **115** at the second point. Thus, the substantially zero-stress condition of the Bragg grating **120** corresponds to a deformation state of the common substrate **313** that is intermediate to the full-scale deformation conditions of the piezoelectric material. At a later stage, possibly directly in use, the emission wavelength of the laser can be tuned by properly biasing the common substrate **313,** applying to the common substrate **313** a voltage higher or lower than the voltage **V** corresponding to the initial zero-stress condition of the Bragg grating, so as to vary the position of the Bragg grating equivalent mirror and thus tune the emission wavelength of the laser.

A second tuning procedure calls for preliminarily bringing the deformable common substrate **313** of piezoelectric material to a selected one of the two opposite full-scale deformation conditions, i.e. maximum extension or maximum contraction; this can be done by applying to the common substrate **313** a suitable voltage **V,** through the electrodes **315a** and **315b;** for example, a voltage **V** substantially equal to zero may correspond to a rest condition of the material, corresponding (case (a)) for example to the maximum contraction (first full-scale), while a voltage **V** equal to the maximum applicable voltage may correspond (case (b)) to a maximum extension condition of the material (second full-scale). Before attaching the fiber **115** at the second point, it is ensured that the laser emission wavelength is slightly lower (in case (a)) or slightly higher (in case (b)) than the target wavelength, e.g. the center-band wavelength of the selected ITU channel. This can be done by monitoring the emission wavelength of the laser by means of a suitable instrument, e.g. the spectrum analyzer **140,** and if necessary, applying a controlled (axial) stress to the fiber **115,** thus to the Bragg grating **120.** The fiber **115** is then bonded **135b** to the second bonding site **310a.** In this way, the emission wavelength of the laser can be tuned even at a later time, possible in use, by applying a suitable voltage to the piezoelectric common substrate **313.** In particular, in case (a), by applying to the piezoelectric material a voltage **V** higher than zero, the common substrate **313** is caused to extend, thus a shift of the laser emission wavelength towards the red is achieved; in case (b), by applying to the piezoelectric material a voltage **V** lower than the maximum voltage, the extension of the common substrate **313** is reduced, thus a shift towards the blue of the emission wavelength is achieved.

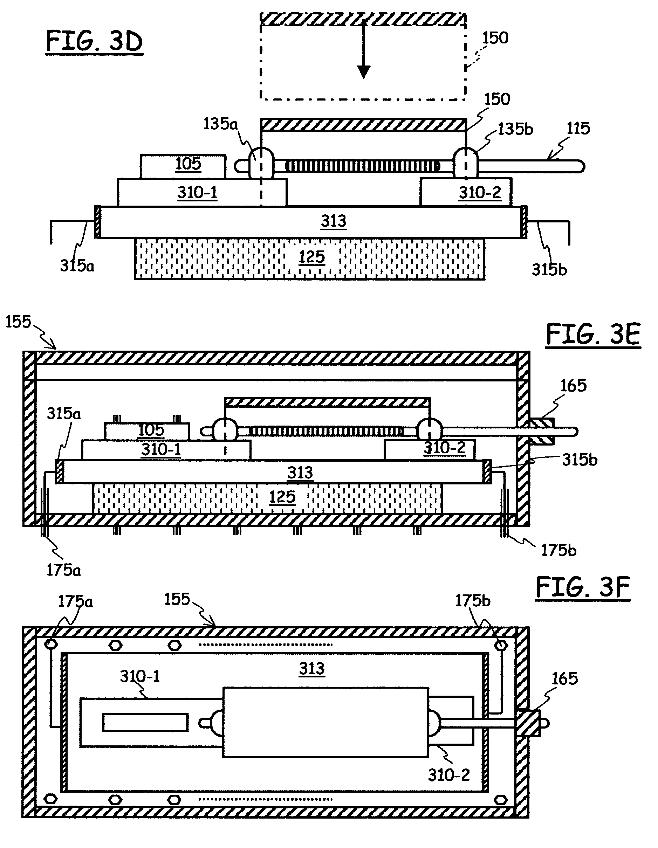

Referring to **Figure 3D,** as in the first embodiment described, the thermally-conductive cap **150** is preferably provided, positioned astride the fiber section in which the Bragg grating is formed, and it is attached, preferably bonded to the common substrate **313,** for example at two elongated bonding areas **313c, 313d,** for example metal strips, that extend aside the fiber section containing the Bragg grating **120,** between the first and second fiber bonding sites **310a** and **310b.** The cap **150,** being of thermally-conductive material and being in thermal contact with the common substrate **313,** which in turn is thermally-regulated by the peltier cell **125,** ensures that, in operation, the temperature of the Bragg grating **120** is kept substantially constant, irrespective from temperature variations in the environment surrounding the Bragg grating.

The OSA **300** may at this point be placed in the respective package 155, as schematically shown in **Figures 3E** and **3F.** Two **175a, 175b** of the reophores **175** that protrude from the package are in this case connected to the electrodes **315a** and **315b** of the common substrate **313,** so as to enable finely tuning the laser emission wavelength directly by the user.

Compared to the first embodiment described, this second embodiment offers the possibility of tuning the emission wavelength directly by the user, while preserving the precision and stability over time properties.

The invention embodiments described so far have made reference to an HDBR laser, including an active optical device such as a laser diode.

The present invention is not limited to this kind of application, being instead in general applicable to optical devices including a Bragg grating whose wavelength needs to be tuned and made stable.

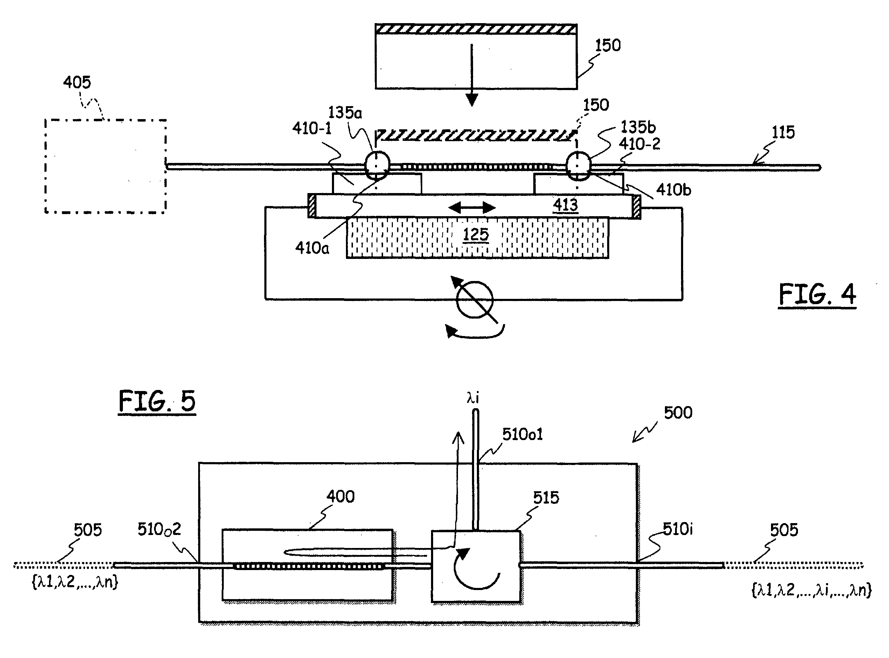

For example, in **Figure 4** there is schematically shown a different optical device **400,** including an optical fiber span **115** in which a Bragg grating **120** is formed. Similarly to the second embodiment described in the foregoing, two substrates **410-1** and **410-2** are provided, attached to a common substrate **413** of controllably deformable material, particularly a slab of piezoelectric material. The two substrates **410-1** and **410-2** include each a respective fiber bonding site **410a,** 410b, for bonding the fiber **415** in two regions thereof, located before and after the Bragg grating **420**. The common substrate **413** has two electrodes **415a** and **415b** through which a voltage can be applied to the common substrate **413** so as to induce deformation thereof.

The packaging of the optical device **400** can proceed as described in connection with the second embodiment; in order to monitor the optical device emission wavelength, an external optical source **405** may be used.

Preferably, the provision of the thermally-conductive cap **150** ensures thermal stability of the Bragg grating.

The optical device **400** can for example be used in an optical receiver **500,** schematically depicted in terms of functional blocks in **Figure** 5, for the use e.g. in a WDM optical communications system. The receiver **500** has an input port **510i** connected to an optical communication line **505** of the optical communication system, a first output port **510o1** for connection to a local branch of the communication system, e.g. a local user equipment or a local sub-network, and a second output port **510o2** for the connection to the optical communication line **505.** Through the input port **510i,** a multiple wavelength optical signal, e.g. a WDM signal, is fed to an optical circulator **515.** Between a first output of the optical circulator **515** and the second output port **510o2** of the receiver there is inserted the optical device **400,** that acts as a wavelength-selective filter, reflecting back optical signals (centered around) a selected (center) wavelength λi. The reflected signal is returned to the optical circulator **515**, and is outputted through the first output port **510o1,** while the remaining component signals of the WDM signal, at different wavelengths, are passed through the device **400** and returned to the optical communication line **505.** Thanks to the invention embodiment described in the foregoing in connection with **Figure 4,** the device **400** can be made tunable, e.g. by acting on the piezoelectric material of the common substrate **413;** it is thus possible to realize a tunable optical receiver, that can be tuned onto the desired wavelength λi .

Although the present invention has been disclosed and described by way of some embodiments, it is apparent to those skilled in the art that several modifications to the described embodiments, as well as other embodiments of the present invention are possible without departing from the scope thereof as defined in the appended claims.

## Claims

1. A method of producing an optical device including a Bragg grating **(120)** formed in an optical waveguide **(115),** the method comprising:
providing a support substrate **(110;310-1,310-2,113;410-1,410-2,413);**
positioning the optical waveguide on the substrate with respect to an optical source **(105;405)** so as to achieve a desired optical coupling of optical power emitted by the optical source into the optical waveguide;
attaching the waveguide to the support substrate **(110a,135a;310a,135a;410a,410b)** in correspondence of a first location along the waveguide, said first location being at one side of the Bragg grating;
attaching the waveguide to the support substrate (**110b,135b;310b,135b**) in a correspondence of a second location along the waveguide, said second location being at an opposite side of the Bragg grating, so as to block the Bragg grating in a first stressed condition.

2. The method according to claim 1, in which said attaching comprises:
providing a first and a second solder-wettable areas (**110a,110;310a,310b**) on said support substrate;
providing solder-wettable areas at said first and second locations along the waveguide;
bonding by soldering the solder-wettable area at the first location along the waveguide to the first solder-wettable area on the support substrate, and the solder-wettable area at the second location along the waveguide to the second solder-wettable area on the support substrate.

3. The method according to claim 1 or 2, further comprising:
applying a stress to the Bragg grating so as to vary a frequency response thereof.

4. The method according to claim 3, in which said applying a stress to the Bragg grating includes applying a mechanical stress to the waveguide.

5. The method according to claim 4, in which said applying a stress is performed before attaching the waveguide to the support substrate in a correspondence of the second location along the waveguide, and the Bragg grating is blocked in the first stressed condition when a target frequency response is attained.

6. The method according to claim 3 or 4, in which said applying a mechanical stress to the waveguide include deforming the support substrate **(313;413).**

7. The method according to claim 6, in which said applying a mechanical stress to the waveguide is performed after attaching the waveguide to the support substrate in a correspondence of the second location along the waveguide, so as to vary the frequency response of the Bragg grating with respect to the frequency response corresponding to the first stress condition, and keeping the Bragg grating in a second stressed condition when a target frequency response is attained.

8. The method according to claim 7, in which the first stressed condition is such that the Bragg grating frequency response is slightly different from the target frequency response, and with the support substrate in either one of two full-scale deformation conditions.

9. The method according to any one of the preceding claims, further comprising:
providing the support substrate with thermal conduction properties; and
thermally-stabilizing **(125)** the support substrate.

10. The method according to claim 9, further comprising:
thermally shielding **(125)** the Bragg grating.

11. The method according to claim 10, in which said thermally shielding comprises:
providing an enclosure **(150)** around the Bragg grating, said enclosure being thermally conductive and being in thermal conduction relationship with the thermally-stabilized support substrate.

12. An optical device comprising:
an optical waveguide **(115),**
a Bragg grating **(120)** formed in the waveguide;
a support substrate **(110;310-1,310-2,113;410-1,410-2,413),**
**characterized by** comprising:
a first and a second waveguide attachment locations, at which the waveguide is attached to the support substrate, said first and second attachment locations being located at opposite side with respect to the Bragg grating, so as to block the Bragg grating in a first stressed condition.

13. The optical device according to claim 12, in which said support substrate **(313;413)** is controllably deformable, a deformation of the substrate causing a stress applied to the Bragg grating that induces a change in a frequency response thereof.

14. The optical device according to claim 13, in which said support substrate comprises:
a first substrate **(310-1;410-1)** including said first waveguide attachment location;
a second substrate **(310-2;410-2)** including said second waveguide attachment location, and
a common substrate **(313;413)** to which the first and second substrates are attached, the common substrate being of a controllably deformable material.

15. The optical device according to claim 14, in the common substrate is in a piezoelectric material.

16. The optical device according to any one of claims 11 to 15, in which the support substrate is thermally conductive, and is associated with a thermal stabilizer **(125)** adapted to substantially stabilize a temperature of the substrate.

17. The optical device according to claim 16, further comprising a thermal shield **(125)** for the Bragg grating.

18. The optical device according to claim 17, in which said thermal shield comprises thermally conductive enclosure **(150)** surrounding the Bragg grating, said enclosure being in thermal conduction relationship with the thermally-stabilized support substrate.

19. The optical device according to any one of claims 12 to 18, further comprising an optical source **(105)** optically coupled to the waveguide.

20. The optical device according to claim 19, in which said optical source includes a laser diode.

21. A method of tuning an optical device including a Bragg grating **(120)** formed in an optical waveguide **(115),** the method comprising:
providing a support substrate (**110;310-1,310-2,113;410-1,410-2,413**);
positioning the optical waveguide on the substrate with respect to an optical source **(105;405)** so as to achieve a desired optical coupling of optical power emitted by the optical source into the optical waveguide;
attaching the waveguide to the support substrate **(110a,135a;310a,135a;410a,410b)** in correspondence of a first location along the waveguide, said first location being at one side of the Bragg grating;
attaching the waveguide to the support substrate **(110b,135b;310b,135b)** in a correspondence of a second location along the waveguide, said second location being at an opposite side of the Bragg grating;
wherein a stress is applied to the Bragg grating so as to vary a frequency response thereof.

22. The method according to claim 21, in which said stress is applied to the Bragg grating before said attaching the waveguide to the support substrate **(110b,135b;310b,135b)** in a correspondence of a second location along the waveguide.

23. The method according to claim 21, in which said stress is applied to the Bragg grating after said attaching the waveguide to the support substrate **(110b,135b;310b,135b)** in a correspondence of a second location along the waveguide.

24. A tunable optical device including:
an optical waveguide **(115),**
a Bragg grating **(120)** formed in the waveguide;
a support substrate **(110;310-1,310-2,113;410-1,410-2,413),**
**characterized in that**:
a first and a second waveguide attachment locations are provided, at which the waveguide is attached to the support substrate, said first and second attachment locations being located at opposite side with respect to the Bragg grating;
and **in that**
the support substrate includes a controllably deformable material substrate **(413),** adapted to be controllably deformed so as to controllably vary a stress condition of the Bragg grating, whereby a frequency response of the optical device can be tuned.
